# EUROPEAN PATENT SPECIFICATION

(11) **EP 3 474 029 B1**
(45) Date of publication and mention of the grant of the patent: **30.03.2022**
(21) Application number: 17815058.7
(22) Date of filing: 16.05.2017
(51) Int. Cl.: G01R 31/34, G01R 31/00

(54) **LOAD ABNORMALITY DETECTION DEVICE**
LASTABWEICHUNGDETEKTIONSVORRICHTUNG
DISPOSITIF DE DÉTECTION D'ANOMALIE DE CHARGE

(30) Priority: 21.06.2016 JP 2016122420
(43) Date of publication of application: 24.04.2019
(73) Proprietor: Mitsubishi Electric Corporation, Chiyoda-ku Tokyo 100-8310 (JP)
(72) Inventor: MIYAUCHI Toshihiko, Tokyo 100-8310 (JP)
(74) Representative: Witte, Weller & Partner Patentanwälte mbB
(86) International application number: PCT/JP2017/018284
(87) International publication number: WO 2017/221588

(56) References cited:
- EP-A1- 1 298 511
- EP-A2- 1 489 475
- JP-A- 2006 153 855
- JP-A- 2008 271 771
- JP-A- 2010 288 352
- JP-A- 2010 288 352
- JP-A- 2015 227 889
- JP-A- 2016 090 546
- US-A1- 2013 338 939
- US-A1- 2014 365 177
- US-B1- 7 308 322
- SAPENA-BANO A ET AL: "Support vector machine for diagnosis of inductioi motors: A comparative analysis in terms of the quantity and the signal processing tool used to build the feature space", 2013 9TH IEEE INTERNATIONAL SYMPOSIUM ON DIAGNOSTICS FOR ELECTRIC MACHINES, POWER ELECTRONICS AND DRIVES (SDEMPED), IEEE, 27 August 2013 (2013-08-27), pages 150-156, XP032514213, DOI: 10.1109/DEMPED.2013.6645710 [retrieved on 2013-10-23]
- ANTONINO-DAVIU JOSE A ET AL: "Case stories of induction motors fault diagnosis based on current analysis", 2016 PETROLEUM AND CHEMICAL INDUSTRY CONFERENCE EUROPE (PCIC EUROPE), PCIC EUROPE, 14 June 2016 (2016-06-14), pages 1-9, XP032988034, DOI: 10.1109/PCICEUROPE.2016.7604635 [retrieved on 2016-10-20]

## Description

### TECHNICAL FIELD

The present invention relates to a load abnormality detection device which is used in a control center such as an enclosed switchboard, for example, and which detects abnormality in a load in a facility apparatus or the like driven by an induction motor.

### BACKGROUND ART

Conventionally, a facility abnormality diagnosis method has been proposed in which: load current of an induction motor is measured; frequency analysis is performed; and with side bands that occur at both sides of the operating frequency being focused on, and on the basis of the state of disturbance of the waveform in the up-down direction in a short period and the state of undulation which is vibration of the waveform in the up-down direction in a long period, abnormalities in an induction motor and an apparatus driven by the induction motor are diagnosed (for example, Patent Document 1).

### CITATION LIST

### PATENT DOCUMENT

Patent Document 1: Japanese Patent No. 4782218

EP 1 489 475 A2 is directed at a power meter or overload relay including a housing and a plurality of sensors configured to monitor operation of a motor. A processor is disposed within the housing and is configured to receive operational feedback from the plurality of sensor and proactively determine an operational wellness of the motor from the operational feedback.

JP 2010-288352 A relates to the abnormality-diagnosis method of an installation. It is suitably used for diagnosing abnormality of the installation containing an induction motor, i.e. an electric motor, and the apparatus driven with an electric motor.

JP 2016-090546 A discloses a current diagnostic device and a current diagnosing method related to unusual diagnostic art using a current diagnostic method.

EP 1 298 511 A1 discloses systems and methods are disclosed for controlling, diagnosing and prognosing the health of a motorized system. The systems may comprise a diagnostics system, a prognostic system and a controller, wherein the diagnostics system and/or prognostic system employs a neural network, an expert system, and/or a data fusion component in order to assess and/or prognose the health of the motorized system according to one or more attributes associated therewith.

### SUMMARY OF THE INVENTION

### PROBLEMS TO BE SOLVED BY THE INVENTION

In the case of a conventional facility abnormality diagnosis method, when variation of the load torque of an induction motor has occurred, spectrum intensities at both sides in the vicinity of the power supply frequency (operating frequency) increase and become greater than the vibration intensities of a sideband wave that occurs in a peak shape at both sides of the power supply frequency, thereby causing a problem of difficulty in detection of the sideband wave.

The present invention has been made in order to solve the above problem. An object of the present invention is to provide, even in the case of an electric motor of which load torque varies, a load abnormality detection device that can detect an abnormality in a load driven by the electric motor on the basis of a spectrum peak series of a sideband wave that occurs in a peak shape at both sides of the vicinity of a power supply frequency.

### SOLUTION TO THE PROBLEMS

The invention is defined by a load abnormality detection device according to claim 1.

### EFFECT OF THE INVENTION

According to the present invention, a current input unit for detecting and inputting current of an electric motor; an FFT analysis unit for analyzing a power spectrum of the current when the current from the current input unit is in a stable state; a peak detection calculation unit for detecting a peak of the power spectrum obtained by the FFT analysis unit; an averaging calculation unit for averaging a plurality of power spectrums analyzed by the FFT analysis unit; a sideband wave extraction unit for extracting a sideband wave of a power spectrum obtained as a result of the averaging performed by the averaging calculation unit; and a spectrum peak series determination unit for determining an abnormality when a spectrum peak series of the sideband wave extracted by the sideband wave extraction unit is different from a spectrum peak series of a sideband wave in a normal time, are provided. Therefore, if the FFT analysis unit performs power spectrum analysis when current is in a stable state, peaks that occur at both sides of the power supply frequency can be assuredly detected. In addition, when a plurality of power spectrums are averaged by the averaging calculation unit, the signal intensity of a peak that has been mixed in a power spectrum due to noise or the like is reduced, and the sideband wave can be more assuredly extracted by the sideband wave extraction unit. Therefore, the present invention has an effect of being able to provide, even in the case of an electric motor of which load torque varies, a load abnormality detection device that can detect an abnormality in a load driven by the electric motor on the basis of a power spectrum series of a sideband wave that occurs in a peak shape at both sides of the vicinity of a power supply frequency.

### BRIEF DESCRIPTION OF THE DRAWINGS

[FIG. 1] FIG. 1 is a schematic configuration diagram showing an installation state of a load abnormality detection device in embodiment 1 of the present invention.
[FIG. 2] FIG. 2 is a block diagram showing a configuration of a logic calculation unit of the load abnormality detection device in embodiment 1 of the present invention.
[FIG. 3] FIG. 3 is an explanatory diagram describing a frequency analysis result obtained by the load abnormality detection device when load variation of an electric motor is large, in embodiment 1 of the present invention.
[FIG. 4] FIG. 4 is an explanatory diagram describing conversion of a frequency axis performed in the load abnormality detection device in embodiment 1 of the present invention.
[FIG. 5] FIG. 5 is a flow chart describing operation of the load abnormality detection device in embodiment 1 of the present invention.
[FIG. 6] FIG. 6 is an explanatory diagram describing setting of a threshold for the load abnormality detection device in embodiment 1 of the present invention.
[FIG. 7] FIG. 7 is an explanatory diagram describing a spectrum peak series in the load abnormality detection device in embodiment 1 of the present invention.
[FIG. 8] FIG. 8 is an explanatory diagram describing spectrum peaks observed in the load abnormality detection device when deflection has occurred in a belt in embodiment 2 of the present invention.
[FIG. 9] FIG. 9 is an explanatory diagram describing spectrum peaks observed in the load abnormality detection device when fraying has occurred in a belt in embodiment 2 of the present invention.

### DESCRIPTION OF EMBODIMENTS

Hereinafter, embodiments of the present invention will be described. In the drawings, the same or the corresponding components are denoted by the same reference characters.

### Embodiment 1.

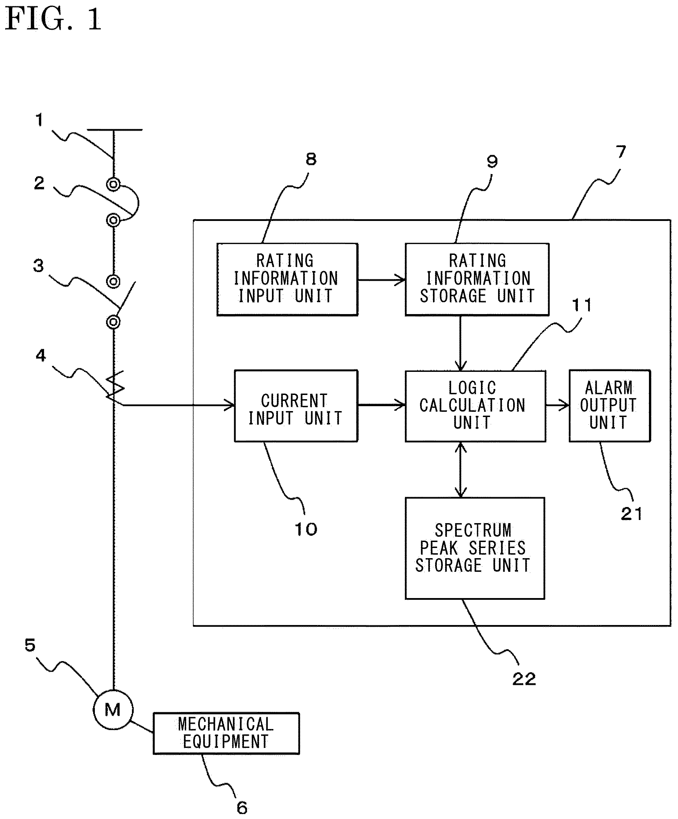

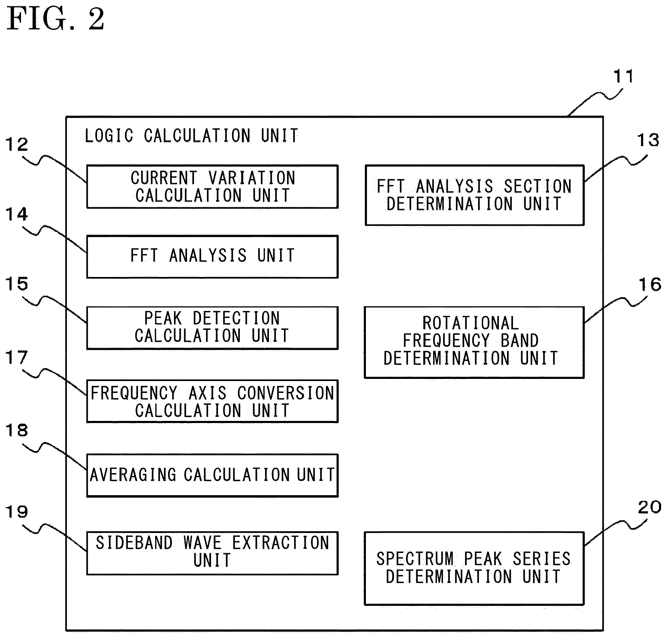

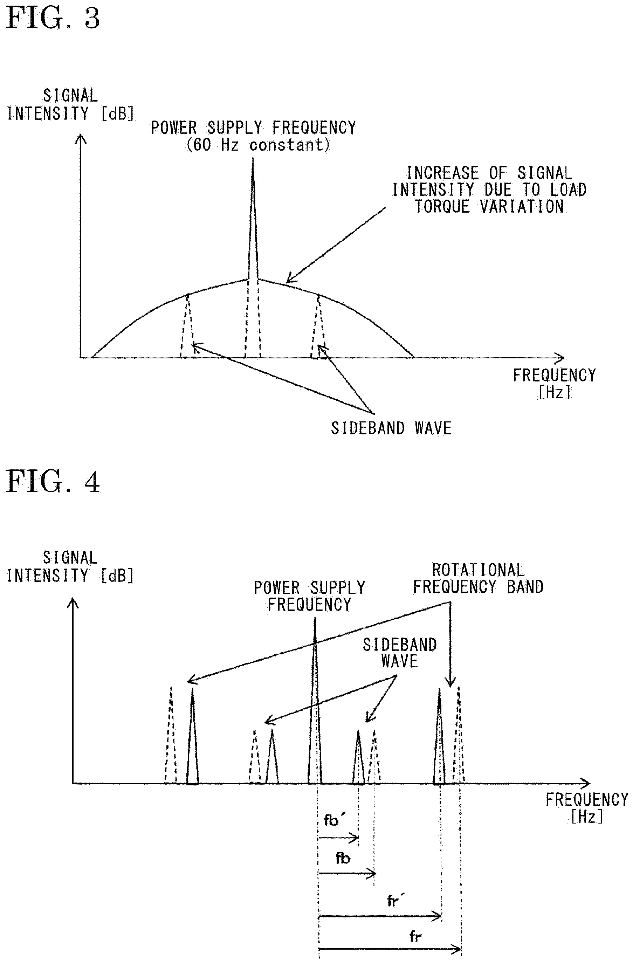

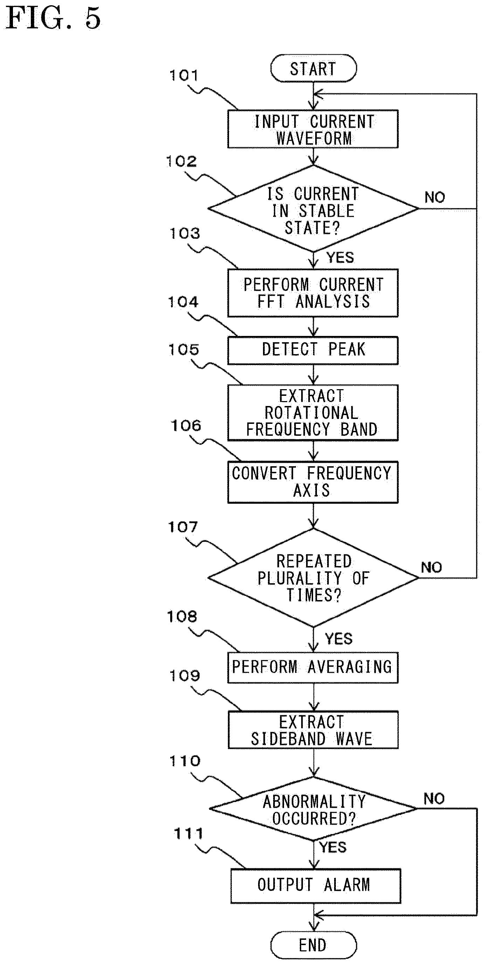

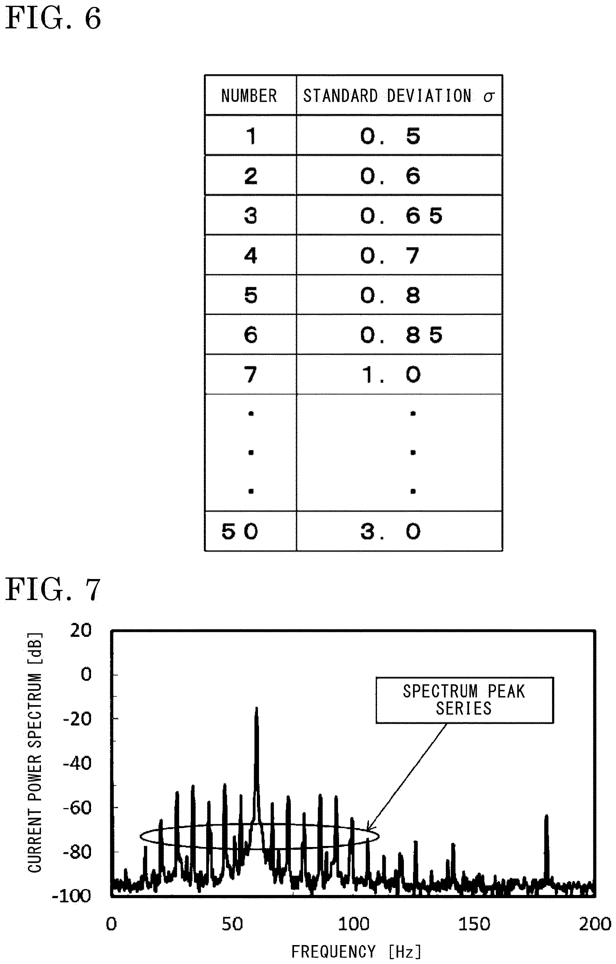

FIG. 1 is a schematic configuration diagram showing an installation state of a load abnormality detection device in embodiment 1 of the present invention. FIG. 2 is a block diagram showing a configuration of a logic calculation unit of the load abnormality detection device in embodiment 1 of the present invention. FIG. 3 is an explanatory diagram describing a frequency analysis result obtained by the load abnormality detection device when load variation of an electric motor is large, in embodiment 1 of the present invention. FIG. 4 is an explanatory diagram describing conversion of a frequency axis performed in the load abnormality detection device in embodiment 1 of the present invention. FIG. 5 is a flow chart describing operation of the load abnormality detection device in embodiment 1 of the present invention. FIG. 6 is an explanatory diagram describing setting of a threshold for the load abnormality detection device in embodiment 1 of the present invention. FIG. 7 is an explanatory diagram describing a spectrum peak series in the load abnormality detection device in embodiment 1 of the present invention.

In FIG. 1, a main circuit 1 drawn from an electric power system is provided with: a circuit breaker 2; an electromagnetic contactor 3; and a current detector 4 such as an instrument transformer which detects load current of one phase of the three-phase main circuit 1. An electric motor 5 such as a three-phase induction motor serving as a load is connected to the main circuit 1, and mechanical equipment 6 is belt-driven to be operated by the electric motor 5. A load abnormality detection device 7 is provided with: a rating information input unit 8 having inputted therein in advance a rated output, a rated voltage, a rated current, the number of poles, a rated revolution speed, and the like of the electric motor 5 and a power supply frequency; and a rating information storage unit 9 for storing rating information inputted from the rating information input unit 8. The rating information is information that can be easily obtained by seeing a catalog from the manufacturing company of the electric motor 5 or a name plate attached to the electric motor 5. In the case where a plurality of electric motors 5 are to be diagnosed, rating information of all the electric motors 5 to be diagnosed is inputted in advance. However, in the following, a case where one electric motor 5 is to be diagnosed is described. In addition, the load abnormality detection device 7 is provided with: a current input unit 10 for inputting current detected by the current detector 4; a logic calculation unit 11 for detecting the presence/absence of an abnormality in a load such as the electric motor 5 and the mechanical equipment 6, by use of current inputted from the current input unit 10; an alarm output unit 21 for outputting an alarm by means of an alarm or by lighting an abnormality lamp, or the like when an abnormality has been found by the logic calculation unit 11; and a spectrum peak series storage unit 22 in which a spectrum peak series in the normal time is stored.

A configuration of the logic calculation unit 11 is described with reference to FIG. 2. The logic calculation unit 11 is composed of: a current variation calculation unit 12 for determining the presence/absence of variation in current inputted from the current input unit 10; an FFT analysis section determination unit 13 for determining a power spectrum analysis section by extracting a section in which current is stable, by use of the result obtained by the current variation calculation unit 12; an FFT analysis unit 14 for performing power spectrum analysis by use of current in the section determined by the FFT analysis section determination unit 13; a peak detection calculation unit 15 for detecting a peak part included in the power spectrum analyzed by the FFT analysis unit 14; a rotational frequency band determination unit 16 for determining a peak part due to the rotational frequency on the basis of the peak part detected by the peak detection calculation unit 15; a frequency axis conversion calculation unit 17 for adjusting the frequencies of the rotational frequency bands of a plurality of power spectra to be the same with one another; an averaging calculation unit 18 for performing an averaging process on the plurality of power spectra of which frequency axes have been converted by the frequency axis conversion calculation unit 17; a sideband wave extraction unit 19 for extracting any peak parts at both sides of the power supply frequency other than at the rotational frequency band, by use of the power spectrum obtained as a result of the averaging performed by the averaging calculation unit 18 (hereinafter, the peak parts will be referred to as a sideband wave); and a spectrum peak series determination unit 20 for determining the presence/absence of an abnormality in a load on the basis of a spectrum peak series based on the sideband wave extracted by the sideband wave extraction unit 19.

The current variation calculation unit 12 calculates a statistical dispersion of the current value on the basis of the current inputted from the current input unit 10. Examples of the technique for dispersion calculation include standard deviation, Mahalanobis' distance, and the like.

On the basis of the statistical dispersion of the current value obtained by the current variation calculation unit 12, the FFT analysis section determination unit 13 determines a power spectrum analysis section by extracting only a current section in which the current value is in a stable state in which the dispersion is not greater than a threshold. In general, when the load torque of the electric motor 5 is varying, a dispersion occurs in the current value, and if power spectrum analysis of a current waveform having a large dispersion is performed, the signal intensities at both sides of the vicinity of the power supply frequency increase, as shown in FIG. 3, and a peak part such as a sideband wave does not appear. In order to prevent this, the threshold for the FFT analysis section determination unit 13 is provided.

The FFT analysis unit 14 performs frequency analysis by use of the current waveform inputted in the section determined by the FFT analysis section determination unit 13, thereby calculating a current power spectrum intensity. When power spectrum analysis is performed by use of a current waveform in a state where the current value is stable, the power spectrum intensities at both sides of the vicinity of the power supply frequency do not increase. As a result, if there is a peak part, the peak part assuredly appears.

On the basis of the analysis result of the current power spectrum intensity, the peak detection calculation unit 15 detects any peak part due to the power supply frequency, any peak part due to the rotational frequency, any peak part due to the sideband wave, and any other peak part. A peak part can be detected by extracting a part in which a steep slope is inverted in a result obtained by first-order, second-order, and third-order differential calculations. By performing differential calculation up to the third order, a peak part having a smaller signal intensity can be detected. The peak part due to the power supply frequency occurs at a position of the power supply frequency (50 Hz or 60 Hz in general) stored in the rating information storage unit 9, and thus, can be easily confirmed.

The rotational frequency band determination unit 16 obtains a rotational frequency from the rated revolution speed stored in the rating information storage unit 9, and extracts peak parts having a similar signal intensity and present at the vicinities of positions shifted by the rotational frequency at both sides with reference to the power supply frequency. In general, in the electric motor 5, slip occurs in accordance with the state of the load torque, and the revolution speed slightly changes. Accordingly, the peak parts due to the rotational frequency appear, shifted corresponding to the change. The rotational frequency band determination unit 16 extracts peak parts in a frequency band in consideration of this change, and determines the extracted peak parts as a rotational frequency band.

The frequency axis conversion calculation unit 17 is necessary in order for the averaging calculation to be properly performed in the averaging calculation unit 18. In general, the position where the sideband wave occurs due to an abnormality or the like of the electric motor 5 has a close relationship with the rotational frequency band, and the frequency band of the sideband wave is a multiple of the rotational frequency band in many cases. In addition, as described above, the rotational frequency band appears, shifted in accordance with the state of the load torque of the electric motor 5.

Thus, with respect to a plurality of power spectrum analysis results to be averaged, it is necessary that the frequency axes thereof are aligned in a peak-part-following manner. Specifically, as shown in FIG. 4, if the frequency of the rotational frequency band is at a position with a distance of fr from the power supply frequency, the frequency of the side band is at a position with a distance of fb from the power supply frequency, and the frequency of the rotational frequency band in a state where the electric motor 5 is under load is at a position with a distance of fr' from the power supply frequency, a conversion rate α is α=fr'/fr, and a position fb' of the sideband wave at the time of under-load can be obtained as fb'=α·fb. In this manner, by performing multiplication by the conversion rate α while using the rotational frequency band as a reference, conversion of the frequency axis at each of all the peak parts is performed. In the description above, a case where the frequency axis is aligned to that at the time of no-load has been described. However, it is sufficient that the frequency axis conversion calculation unit 17 is configured so as to align the frequency axes of a plurality of power spectrum analysis results to be averaged, to a frequency axis at the time of a predetermined load, such as aligning each frequency axis to a frequency axis at the time of a rated load, or the like.

The averaging calculation unit 18 performs an averaging process on a plurality of power spectrum analysis results of which frequency axes have been aligned in the frequency axis conversion calculation unit 17. By performing the averaging process, the averaging calculation unit 18 can reduce base noise, thereby improving the S/N ratio at peak parts. Specifically, if 10 power spectrum analysis results are subjected to the averaging process, the signal intensity of a peak part that is due to noise or the like and that has occurred only once is reduced to one tenth of the original signal intensity. Meanwhile, in the case of the rotational frequency band or the sideband wave, peak parts occur in all of 10 times, and the frequency axes have been converted in a peak-following manner so that the frequencies are the same with one another. Therefore, even when averaging is performed, the signal intensities of the peak parts do not change. In the description above, although a case where 10 power spectrum analysis results are averaged has been described, the number of power spectrum analysis results is not limited to 10, and it is sufficient that a plurality of power spectrum analysis results are averaged.

The sideband wave extraction unit 19 extracts, as a sideband wave, peak parts occurring at the positions shifted by the same frequency at both sides with respect to the power supply frequency, from the power spectrum analysis result obtained through the averaging process performed by the averaging calculation unit 18. As a candidate for the sideband wave, peak parts obtained in the peak detection calculation unit 15 are selected. In the case of a peak part occurring only at one side with respect to the power supply frequency, the peak part is determined not to be a sideband wave and is not extracted.

In the case where the sideband wave extracted by the sideband wave extraction unit 19 does not have a spectrum peak series shown in FIG. 7 which occurs when a load is belt-driven, for example, the spectrum peak series determination unit 20 determines that a load abnormality in which the belt has been broken has occurred. When it has been determined that there is an abnormality in the load, an alarm is outputted from the alarm output unit 21.

Next, operation is described with reference to FIG. 5. The load abnormality detection device 7 is activated at a predetermined time interval, and performs the following process.

In step 101, current of the electric motor 5 detected by the current detector 4 is inputted from the current input unit 10. In step 102, dispersion of the effective value of the current inputted from the current input unit 10 (hereinafter, referred to as a current value) is calculated by the current variation calculation unit 12, and by use of the calculation result, the FFT analysis section determination unit 13 determines whether the current is in a stable state. As the determination result, if the current is in an unstable state (NO) in which the dispersion of the current value is not less than a threshold set in advance, the process returns to step 101, and is repeated until the current enters a stable state. When the current is in a stable state (YES), the process is advanced to step 103. As for the threshold, for example, field data of a plurality of motors is obtained in advance, and from the current dispersion values (standard deviation) of the data, a range in which the dispersion value is small is selected, and the selected value is used as the threshold. As a specific calculation example, for example, as shown in FIG. 6, the dispersion value is calculated 50 times, and 0.8, which is the fifth smallest dispersion value in the 50 dispersion values sorted in an ascending order is determined as a threshold (from a result of a field test). Instead of field data prepared in advance, a certain learning period may be provided for the electric motor 5, and then, similar calculation may be performed from the current dispersion values (standard deviation) obtained during the learning period.

In step 103, by use of the current waveform in the section where the inputted current value is in a stable state, the FFT analysis unit 14 performs frequency analysis from 0 Hz to a frequency of 120 Hz, which is twice 60 Hz of the power supply frequency, and sends the power spectrum analysis result to the peak detection calculation unit 15. In step 104, the peak detection calculation unit 15 detects all the peak parts included in the power spectrum analysis result. In step 105, the rotational frequency band determination unit 16 extracts peak parts in the rotational frequency band among the detected peak parts, and determines the rotational frequency band. In step 106, the frequency axis conversion calculation unit 17 converts the frequency axis of each of all the peak parts such that the detected rotational frequency band becomes the rotational frequency band at the time of no-load. In step 107, the operation from step 101 to step 106 is repeated 10 times, whereby 10 power spectrum analysis results for each of which the frequency axis has been converted are collected.

In step 108, the averaging calculation unit 18 performs an averaging process on the collected 10 power spectrum analysis results. In step 109, the sideband wave extraction unit 19 extracts a sideband wave, focusing on the peak parts in the power spectrum analysis result obtained through the averaging process. In step 110, the spectrum peak series determination unit 20 determines whether the sideband wave extracted by the sideband wave extraction unit 19 has a spectrum peak series in the normal time shown in FIG. 7 and stored in the spectrum peak series storage unit 22, through comparison of the number of peak parts and the positional relationship, and if there is a spectrum peak series that includes peak parts occurring by the same number and at the same positions as the peak parts in the normal time, the spectrum peak series determination unit 20 determines that no abnormality is occurring in the load (NO), and ends the abnormality detection process. Meanwhile, when the sideband wave extracted by the sideband wave extraction unit 19 does not have the spectrum peak series in the normal time shown in FIG. 7 (YES), the spectrum peak series determination unit 20 determines that an abnormality is occurring in the load, and sends a signal to the alarm output unit 21. Then, in step 111, the alarm output unit 21 outputs an alarm by means of an alarm or by lighting an abnormality lamp, or the like, and the process ends.

The spectrum peak series in the normal time shown in FIG. 7, the spectrum peak series being stored in the spectrum peak series storage unit 22 so as to be used in the spectrum peak series determination unit 20, has been obtained in a state where the load is in a normal state at the time of introduction of the load abnormality detection device 7. In general, when the mechanical equipment 6 is being belt-driven by the electric motor 5, a spectrum peak series shown in FIG. 7 occurs due to vibration at the joint in the belt. However, if the belt rips, this spectrum peak series does not occur. Since the spectrum peak series that has been present is no longer present, detection of the ripping of the belt is enabled.

As described above, if power spectrum analysis is performed on the current waveform at the time when the current value is stable, peak parts such as the sideband wave assuredly appear. In addition, if the averaging process is performed, noise and the like are reduced, and more accurate abnormality detection can be performed. Further, since occurrence of an abnormality is determined on the basis of the presence/absence of the spectrum peak series, the abnormality determination process is easy.

### Embodiment 2

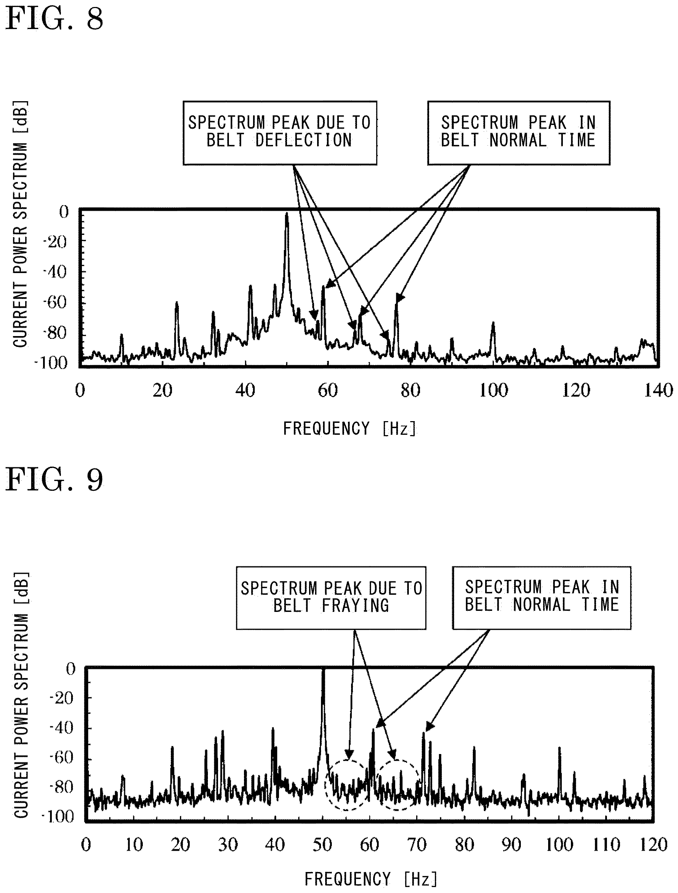

FIG. 8 is an explanatory diagram describing spectrum peaks observed in the load abnormality detection device when deflection has occurred in the belt in embodiment 2 of the present invention. FIG. 9 is an explanatory diagram for describing spectrum peaks observed in the load abnormality detection device when fraying has occurred in the belt in embodiment 2 of the present invention.

In embodiment 1, above, abnormality determination performed by the spectrum peak series determination unit 20 when the belt rips has been described. However, in embodiment 2, abnormality determination performed by the spectrum peak series determination unit 20 when the belt has deteriorated with age is described.

If the belt is elongated due to aged deterioration, deflection occurs in the belt, the revolution speed of the load varies, and the product quality is deteriorated. When deflection has occurred in the belt, as shown in FIG. 8, aside from the spectrum peak series occurring in the normal time of the belt, spectrum peaks due to deflection of the belt occur inside the spectrum peak series in the belt normal time occurring on both sides with respect to the power supply frequency during operation (FIG. 8 shows a case where the power supply frequency is 50 Hz). In the spectrum peak series determination unit 20 shown in FIG. 2, the spectrum peaks that have newly occurred due to the deflection of the belt are detected through comparison with the spectrum peak series in the normal time stored in the spectrum peak series storage unit 22, whereby abnormality due to deflection deterioration of the belt can be determined (detected).

If fraying has occurred in the belt due to aged deterioration and the deterioration advances further, the belt rips in the end. When fraying of the belt has occurred, a plurality of spectrum peaks newly occur between spectrum peaks in the spectrum peak series occurring in the belt normal time as shown in FIG. 9. In the spectrum peak series determination unit 20 shown in FIG. 2, the plurality of spectrum peaks that have newly occurred due to fraying of the belt are detected through comparison with the spectrum peak series in the normal time stored in the spectrum peak series storage unit 22, whereby abnormality due to fraying deterioration of the belt before occurrence of ripping of the belt can be determined (detected).

Since the other components are the same as those described in embodiment 1 above, description thereof is omitted.

### Embodiment 3

In embodiment 2 described above, spectrum peaks when the belt has deteriorated with age have been described. However, for example, also in the case of abnormality in meshing of gears, abnormality in the blades of a fan, or the like, if compared with the spectrum peak series in the normal time, specific spectrum peaks newly occur (not shown), as in the case shown in FIG. 8 or FIG. 9, for example. Therefore, if the specific spectrum peaks are detected, an abnormality state of the load can be detected.

It should be noted that, within the scope of the invention, the embodiments can be freely combined with each other, or each of the above embodiments may be modified or simplified as appropriate.

### DESCRIPTION OF THE REFERENCE CHARACTERS

- 1: main circuit
- 2: circuit breaker
- 3: electromagnetic contactor
- 4: current detector
- 5: electric motor
- 6: mechanical equipment
- 7: load abnormality detection device
- 8: rating information input unit
- 9: rating information storage unit
- 10: current input unit
- 11: logic calculation unit
- 12: current variation calculation unit
- 13: FFT analysis section determination unit
- 14: FFT analysis unit
- 15: peak detection calculation unit
- 16: rotational frequency band determination unit
- 17: frequency axis conversion calculation unit
- 18: averaging calculation unit
- 19: sideband wave extraction unit
- 20: spectrum peak series determination unit
- 21: alarm output unit
- 22: spectrum peak series storage unit

## Claims

1. A load abnormality detection device comprising:
a current input unit (10) for detecting and inputting current of an electric motor (5);
an FFT analysis unit (14) for analyzing a power spectrum of the current when the current from the current input unit (10) is in a stable state;
a peak detection calculation unit (15) for detecting a peak of the power spectrum obtained by the FFT analysis unit (14);
an averaging calculation unit (18) for averaging a plurality of power spectrums analyzed by the FFT analysis unit (14);
a sideband wave extraction unit (19) for extracting a sideband wave of a power spectrum obtained as a result of the averaging performed by the averaging calculation unit (18); and
a spectrum peak series determination unit (20) for determining an abnormality when the number of peak parts or positional relationship of a spectrum peak series of the sideband wave extracted by the sideband wave extraction unit (19) is different from that of a spectrum peak series of a sideband wave in a normal time.

2. The load abnormality detection device according to claim 1, wherein
the averaging calculation unit (18) is adapted to perform the averaging in a state where frequency axes of the plurality of power spectrums have been converted, so that frequencies of rotational bands of the plurality of power spectrums are the same with one another, and peak parts due to a rotational frequency band are aligned.

3. The load abnormality detection device according to claim 1 or 2, wherein
the spectrum peak series determination unit (20) is adapted to determine an abnormality when a spectrum peak series of the sideband wave occurring in a normal time no longer occurs.

4. The load abnormality detection device according to claim 1 or 2, wherein
the spectrum peak series determination unit (20) is adapted to determine an abnormality when a new spectrum peak has occurred between spectrum peaks of the sideband wave occurring in a normal time.

## Patentansprüche

1. Vorrichtung zur Erkennung von Lastabnormalitäten, die Folgendes aufweist:
eine Stromeingabeeinheit (10) zum Erfassen und Eingeben eines Stroms eines Elektromotors (5);
eine FFT-Analyseeinheit (14) zum Analysieren eines Leistungsspektrums des Stroms, wenn der Strom von der Stromeingangseinheit (10) in einem stabilen Zustand ist;
eine Spitzenwerterfassungs-Berechnungseinheit (15) zum Erfassen eines Spitzenwerts des von der FFT-Analyseeinheit (14) erhaltenen Leistungsspektrums;
eine Mittelwertberechnungseinheit (18) zur Mittelung einer Vielzahl von Leistungsspektren, die von der FFT-Analyseeinheit (14) analysiert wurden;
eine Seitenbandwellen-Extraktionseinheit (19) zum Extrahieren einer Seitenbandwelle eines Leistungsspektrums, das als Ergebnis der von der Mittelwertberechnungseinheit (18) durchgeführten Mittelung erhalten wird; und
eine Spektrumsspitzenserien-Bestimmungseinheit (20) zum Bestimmen einer Abnormalität, wenn die Anzahl der Spitzenteile oder die Positionsbeziehung einer Spektrumsspitzenserie der durch die Seitenbandwellen-Extraktionseinheit (19) extrahierten Seitenbandwelle sich von der einer Spektrumsspitzenserie einer Seitenbandwelle zu einer normalen Zeit unterscheidet.

2. Vorrichtung zur Erkennung von Lastabnormalitäten nach Anspruch 1, wobei
die Mittelwertbildungsberechnungseinheit (18) ausgebildet ist, um die Mittelwertbildung in einem Zustand durchzuführen, in dem Frequenzachsen der Vielzahl von Leistungsspektren umgewandelt worden sind, so dass Frequenzen von Rotationsbändern der Vielzahl von Leistungsspektren miteinander gleich sind und Spitzenanteile aufgrund eines Rotationsfrequenzbandes ausgerichtet sind.

3. Vorrichtung zur Erkennung von Lastabnormalitäten nach Anspruch 1 oder 2, wobei
die Spektrumsspitzenserien-Bestimmungseinheit (20) so ausgebildet ist, dass sie eine Abnormalität feststellt, wenn eine Spektrums-Spitzenwertserie der Seitenbandwelle, die zu einer normalen Zeit auftritt, nicht mehr auftritt.

4. Vorrichtung zur Erkennung von Lastabnormalitäten nach Anspruch 1 oder 2, wobei
die Spektrumsspitzenserien-Bestimmungseinheit (20) so ausgebildet ist, dass sie eine Anomalie feststellt, wenn ein neuer Spektrums-Spitzenwert zwischen Spektrums-Spitzenwerten der Seitenbandwelle aufgetreten ist, die zu einer normalen Zeit auftreten.

## Revendications

1. Dispositif de détection d'anomalie de charge comprenant :
une unité d'entrée de courant (10) permettant de détecter et d'entrer du courant d'un moteur électrique (5) ;
une unité d'analyse FFT (14) permettant d'analyser un spectre de puissance du courant lorsque le courant provenant de l'unité d'entrée de courant (10) se trouve dans un état stable ;
une unité de calcul de détection de crête (15) permettant de détecter une crête du spectre de puissance obtenue par l'unité d'analyse FFT (14) ;
une unité de calcul de moyenne (18) permettant de faire la moyenne d'une pluralité de spectres de puissance analysés par l'unité d'analyse FFT (14) ;
une unité d'extraction d'onde de bande latérale (19) permettant d'extraire une onde de bande latérale d'un spectre de puissance obtenue à la suite de la moyenne effectuée par l'unité de calcul de moyenne (18) ; et
une unité de détermination de série de crêtes de spectres (20) permettant de déterminer une anomalie lorsque le nombre de parties de crêtes ou le rapport positionnel d'une série de crêtes de spectres de l'onde de bande latérale extraite par l'unité d'extraction d'onde de bande latérale (19) est différent de celui d'une série de crêtes de spectres d'une onde de bande latérale dans une période de temps normale.

2. Dispositif de détection d'anomalie de charge selon la revendication 1, dans lequel
l'unité de calcul de moyenne (18) est adaptée pour effectuer la moyenne dans un état où des axes de fréquence de la pluralité de spectres de fréquences ont été convertis, de sorte que des fréquences de bandes de rotation de la pluralité de spectres de puissance sont les mêmes les unes par rapport aux autres, et des parties de crêtes dues à une bande de fréquence de rotation sont alignées.

3. Dispositif de détection d'anomalie de charge selon la revendication 1 ou 2, dans lequel
l'unité de détermination de série de crêtes de spectres (20) est adaptée pour déterminer une anomalie lorsqu'une série de crêtes de spectres de l'onde de bande latérale se produisant dans une période de temps normale n'a plus lieu.

4. Dispositif de détection d'anomalie de charge selon la revendication 1 ou 2, dans lequel
l'unité de détermination de série de crêtes de spectres (20) est adaptée pour déterminer une anomalie lorsqu'une nouvelle crête de spectre a eu lieu entre les crêtes de spectres de l'onde de bande latérale se produisant dans une période de temps normale.
